# EUROPEAN PATENT SPECIFICATION

(11) **EP 3 379 908 B1**
(45) Date of publication and mention of the grant of the patent: **29.04.2020**
(21) Application number: 17162828.2
(22) Date of filing: 24.03.2017
(51) Int. Cl.: H05K 7/20

(54) **METHOD FOR MANUFACTURING A FLUID-BASED COOLING ELEMENT AND FLUID-BASED COOLING ELEMENT**
VERFAHREN ZUR HERSTELLUNG EINES FLUIDBASIERTEN KÜHLELEMENTS UND FLUIDBASIERTES KÜHLELEMENT
PROCÉDÉ DE FABRICATION D'UN ÉLÉMENT DE REFROIDISSEMENT À BASE DE FLUIDE ET ÉLÉMENT DE REFROIDISSEMENT À BASE DE FLUIDE

(43) Date of publication of application: 26.09.2018
(73) Proprietor: EKWB d.o.o., 1218 Komenda (SI)
(72) Inventor: Tivadar, Niko, 9250 Gornja Radgona (SI)
(74) Representative: Schaumburg und Partner Patentanwälte mbB

(56) References cited:
- GB-A- 2 536 051
- US-A1- 2005 103 472
- US-A1- 2012 247 743
- US-A1- 2014 043 765
- US-A1- 2014 138 063

## Description

The invention relates to a method for manufacturing a fluid-based cooling element, wherein the fluid-based cooling element is configured for cooling a heat generating element arranged on a printed circuit board (PCB). Further, the invention relates to a fluid-based cooling element for cooling a heat generating element arranged on a printed circuit board.

According to the state of the art, fluid-based cooling systems for cooling of computers and other heat generating electronic and/or electric components arranged on a printed circuit board are normally designed like a conventional car engine fluid-based cooling system. Such a fluid-based cooling system is normally a closed loop setup, comprised of a cold plate, a fluid, a fluid transportation tubing, a fluid cooling pump and a heat exchanger.

Normally, high performance cold plates (i.e. liquid or water blocks) for fluid-based cooling systems are made from a metal base (typically consisting of copper or aluminum) with a high-density heat sink fin structure above the high-heat flux area of the PCB component (typically a high-power microprocessor), a sealing lid with gaskets and inlet and outlet fluid connectors or ports.

Traditionally, the fluid-based cold plates, i.e. liquid or water blocks, are made from one or more raw bars of metal with a high thermal conductivity, in particular by removing (cutting) of the material to final shape. Here, one or more material removing techniques, such as machining, skiving, electro-erosion or other techniques are used. In low-volume production, the known cold plates are almost exclusively made by material cutting since this technique does not require any additional expensive tooling.

In high-volume production, raw metal bars are normally replaced by a die-casted, stamped, forged or extruded metal profile in order to ramp up the production rate. Such a pre-forming to shape reduces the machining time of the known cold plates as normally only a few structural details need to be produced of which the most important and time-consuming is the manufacturing of the heat sink cooling channels.

The heat sink cooling channels of the heat sink fin structure are most commonly made using a small diameter high-speed cutter, a wheel-type slit-saw, electro-erosion or a fin skiving technique. In this way, a linear array of heat sink fins is produced. Normally, the heat sink fin gap size can be made as thin as 0.1 mm in width for skived fins and 0.2 mm in width for slit-saw machined fins, depending on the cold plate material and technology.

In general, the higher the density of the heat sink fin structure or heat sink fin array is, the more efficient is the usage of the cooling surface of the cold plate in the area of the heat sink fin structure or heat sink fin array. Most commonly, a 0.2 mm to 0.8 mm thick heat sink fin structure is used for high-performance cold plates. Alternatively, the heat sink fin structure or heat sink fin array can also be soldered or welded to the base of the cold plate.

Thus, a high-density heat sink fin structure is crucial for achieving a good thermal performance of the cold plate, especially with heat generating PCB components reaching a relatively high heat flux up to 80 W/cm².

US 2014/138063 A1 discloses a cooling fin structure for cooling an electronic device such as a semiconductor device. The cooling fin structure comprises pins with a lentil shaped cross-section arranged between a channel top plate and a channel bottom plate. These fins are integrally formed with the channel top plate or the channel bottom plate by means of casting with an aluminum die.

US 2005/103472 A1 discloses a cold plate comprising a first member and a second member,. each of the first and second members comprising a circular base and fins extruding from said base. The first and second members may be made by any technique for forming parts, including metal die casting.

US 2014/043765 A1 discloses a cooler for a semiconductor module. The cooler comprises a fin base having fins which are integrally formed with the fin base by means of die casting.

GB 2 536 051 A discloses a heat sink for power electronic applications comprising a first plate member and an opposing second plate member. Fins are formed integrally with the first plate member by means of die casting and are arranged between the first and second plate members.

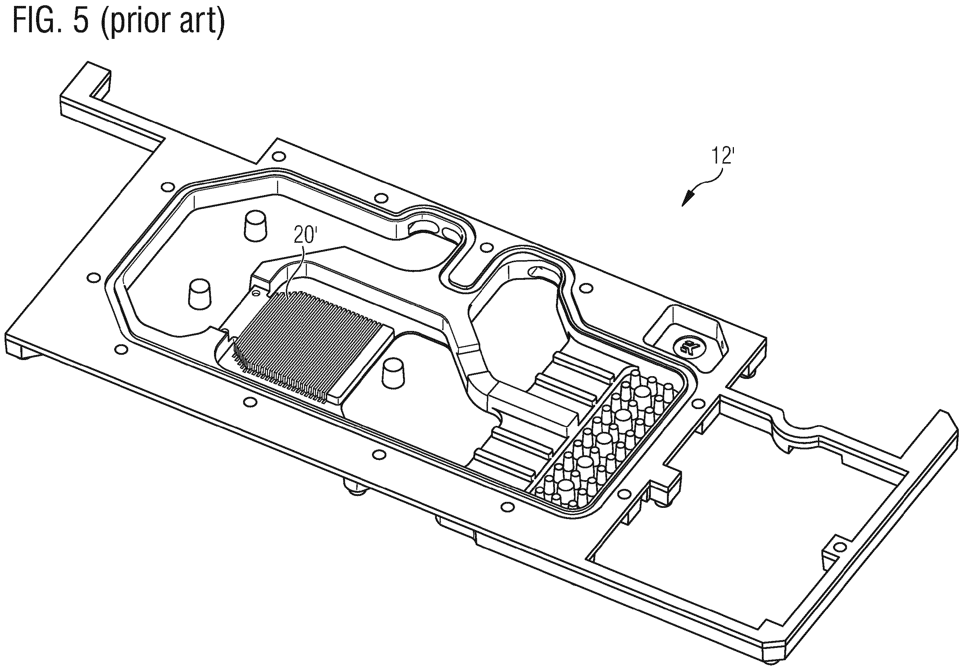

Figure 5 shows a base 12' of a cold plate with such a high-density heat sink fin structure according to the prior art. The base 12' of the cold plate shown in Figure 5 is manufactured by using a known pre-forming technique. Then, the heat sink cooling channels of the heat sink fin structure are manufactured by using a small diameter high-speed cutter, a wheel-type slit-saw, electro-erosion or a fin skiving technique.

However, the use of such a technique drastically increases the production time as it requires additional machining as well as tooling/fixture costs and increases the production costs. In particular, any of the just-mentioned processing steps can amount up to half of the cold plate production costs.

Thus, a general problem of known methods for manufacturing high performance cold plates is that the same are not capable of the production of a high-density heat sink fin structure for achieving a good thermal performance while at the same time avoiding a relatively time-consuming, complicated and costly processing step.

It is an object of the invention to specify a method for manufacturing a fluid-based cooling element which allows for the production of the same in an efficient, simple and economical way while achieving a good thermal performance.

This object is solved by a method having the features of claim 1 and by a fluid-based cooling element having the features of claim 14. Advantageous developments of the invention are specified in the dependent claims.

According to an embodiment, a method for manufacturing a fluid-based cooling element is provided. The fluid-based cooling element is configured for cooling a heat generating element arranged on a printed circuit board. The method comprises forming a base body comprising a plate-shaped based body portion and an inner base body portion integrally formed with the plate-shaped base body portion. The step of forming the base body comprises forming the plate-shaped base body portion and the inner base body portion by means of die casting. The inner base body portion comprises a plurality of protrusions formed on an upper side of the inner base body portion. The protrusions have a gap size in a range of 0.5 mm to 1.5 mm. Preferably, the step of forming the base body comprises forming the plate-shaped base body portion and the inner base body portion in a single processing step. In this way, the production of a fluid-based cooling element can be achieved in an efficient, simple and economical way. Simultaneously, the fluid-based cooling element is characterized by a good thermal performance.

Preferably, the protrusions have a gap size of approximately 1 mm. Thus, on the one hand, a sufficiently high density of a heat sink fin arrangement can be provided, and on the other hand, the heat sink fin arrangement can be made relatively robust.

It is advantageous when the step of forming the base body comprises using an aluminum-silicon die casting alloy, wherein the aluminum-silicon die casting alloy is G-AlSi12. This die casting alloy G-AlSi12 offers excellent die casting properties while maintaining a high thermal conductivity, casting yield rate and corrosion resistance.

Preferably, the aluminum-silicon die casting alloy G-AlSi12 is substantially free of copper. Thus, it is possible to effectively avoid galvanic corrosion which increases the reliability of the fluid-based cooling element.

Alternatively, the step of forming the base body comprises using an aluminum-silicon-magnesium die casting alloy or using an aluminum-magnesium die casting alloy. For example, the aluminum-silicon-magnesium die casting alloy is G-AlSi7Mg, G-AlSi5Mg, G-AlMg5Si or G-AlSi10Mg. Further, the aluminum-magnesium die casting alloy may be G-AlMg3 or G-AIMg5. Thus, several different aluminum-based die casting alloys can be used for the production of the fluid-based cooling element.

It is advantageous when the protrusions extend parallel to an upper surface of the plate-shaped base body portion, when the protrusions define a plurality of fluid channels extending parallel to the upper surface of the plate-shaped base body portion, and when the protrusions are configured as a heat sink fin arrangement. This allows to effectively cool a high-heat flux area arranged below the heat sink fin arrangement.

It is advantageous when a first individual protrusion of the plurality of protrusions extends into a first longitudinal direction parallel to an upper surface of the plate-shaped base body portion, when a second individual protrusion of the plurality of protrusions extends into a second longitudinal direction parallel to the upper surface of the plate-shaped base body portion, when the extension of the first individual protrusion in the first longitudinal direction defines a first angle with respect to a symmetry axis of the plurality of protrusions extending parallel to the upper surface of the plate-shaped base body portion, when the extension of the second individual protrusion in the second longitudinal direction defines a second angle with respect to the symmetry axis of the plurality of protrusions extending parallel to the upper surface of the plate-shaped base body portion, and when the first angle and/or the second angle are equal to or larger than 15° and smaller than 90°. Thereby, a non-linear array of heat sink fins can be provided which increases the length of the fluid channels or heat sink cooling channels and in turn the effective heat sink surface. In addition, the hydraulic performance can also be improved.

Preferably, the first angle and the second angle are of the same size. Thus, a symmetric configuration of the heat sink fin arrangement can be obtained.

It is advantageous when the method further comprises forming a nozzle body comprising a longitudinally extending fluid inlet, wherein the step of forming the nozzle body comprises using an aluminum-based die casting alloy. This allows to provide a central inlet split-flow nozzle which can be used to generate a split fluid flow for the heat sink fin arrangement. Thereby, the thermal performance can be improved while at the same time a hydraulic restriction of the fluid-based cooling element can be decreased.

Preferably, the method further comprises arranging the nozzle body on the inner base body portion, wherein the longitudinally extending fluid inlet is arranged perpendicular above a symmetry axis of the plurality of protrusions formed on the upper side of the inner base body portion. Thereby, the generation of the split fluid flow for the heat sink fin arrangement can be optimized.

Preferably, the method further comprises arranging a sealing element on/or in the plate-shaped base body portion. Thereby, a leakage of the cooling fluid from the fluid chamber can effectively be prevented.

It is advantageous when the method further comprises arranging a sealing body on the plate-shaped base body portion, wherein the plate-shaped base body portion, the inner base body portion and the sealing body together define a fluid chamber, and when the fluid chamber is configured for receiving a cooling fluid. This allows to obtain a controlled and reliable flow of the cooling fluid within the fluid chamber.

According to an embodiment, a fluid-based cooling element for cooling a heat generating element arranged on the printed circuit board comprises a base body comprising a plate-shaped base body portion and an inner base body portion integrally formed with the plate-shaped base body position. The plate-shaped base boy portion and the inner base body portion are formed by means of die casting. The inner base body portion comprises a plurality of protrusions formed on an upper side of the inner base body portion. The protrusions have a gap size in a range of 0.5 mm to 1.5 mm.

For example, the heat generating element may be a microprocessor, integrated circuit, or any other PCB component arranged on the printed circuit board, e.g. a memory IC (RAM), a non-volatile storage IC (flash storage), a bus line switch (PCle switch), an FPGA, an ASIC, an I/O-controller, a PHY controller, a coil, a diode and a voltage converter.

Further features and advantages of the invention result from the following description which explains the invention in more detail on the basis of embodiments in connection with the enclosed schematic figures:
- Figure 1: shows a top perspective view of a base body of an embodiment of a fluid-based cooling element;
- Figure 2: shows a top view of the base body according to Figure 1 illustrating a heat sink fin arrangement;
- Figure 3: shows a top view of an exemplary nozzle body arranged on the heat sink fin arrangement of the base body according to Figure 1;
- Figure 4: shows an exploded view of the embodiment of the fluid-based cooling element fixable to a printed circuit board; and
- Figure 5: shows a top perspective view of a base body of a fluid-based cooling element according to the prior art.

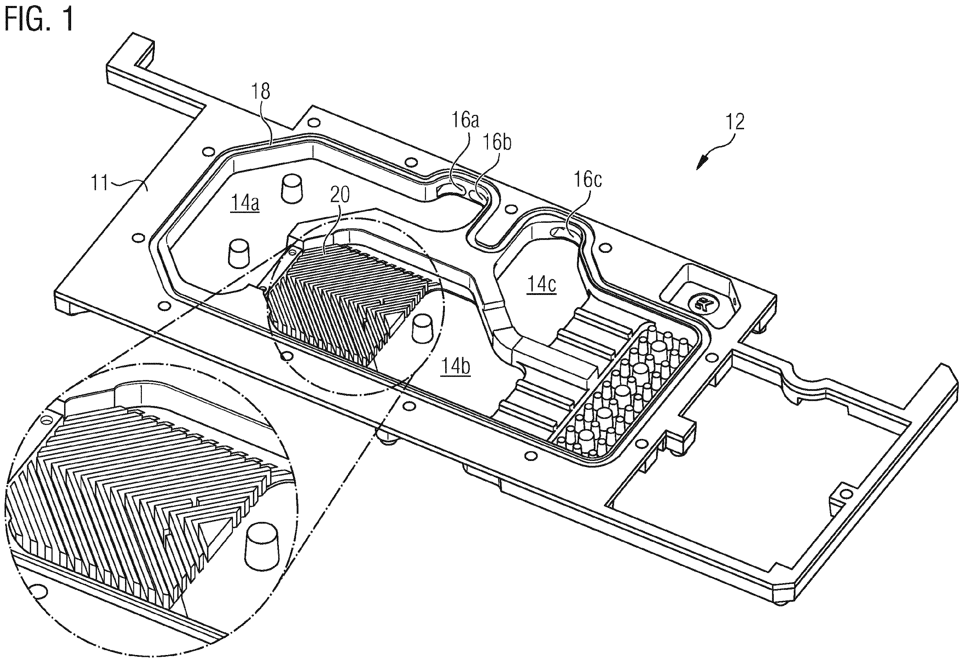

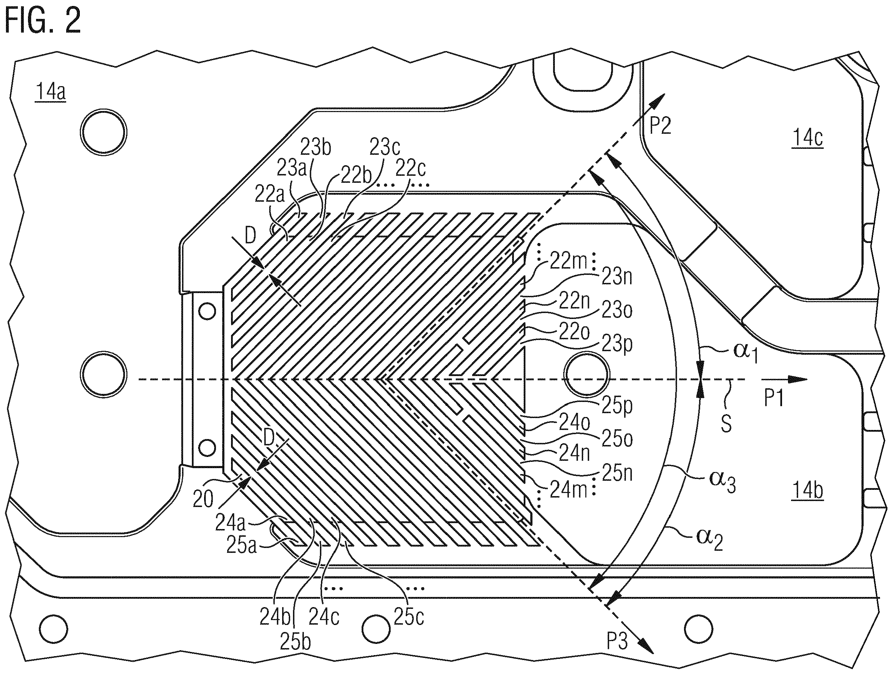

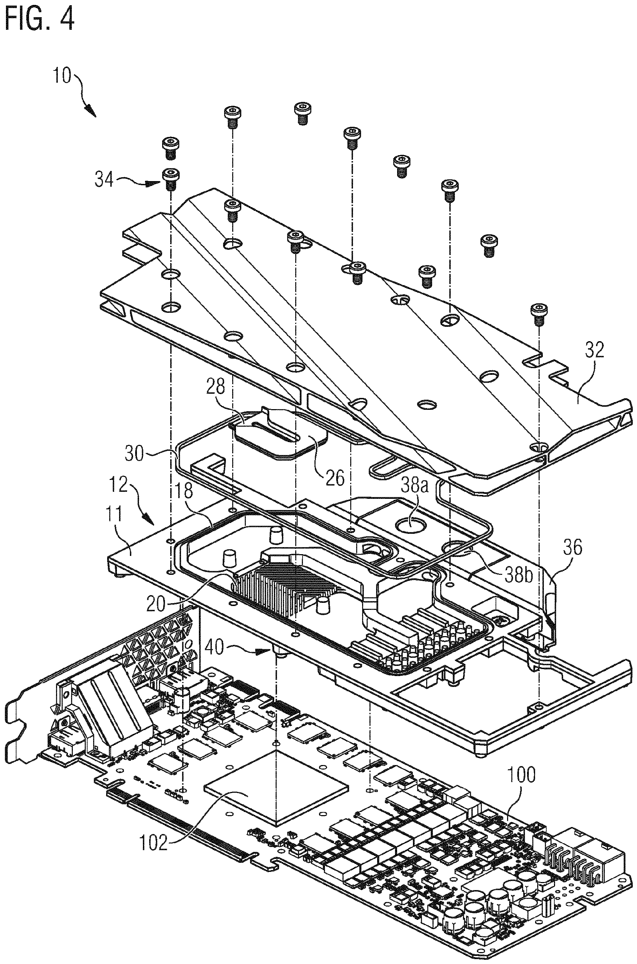

Figure 1 shows a top perspective view of a base body 12 of an embodiment of a fluid-based cooling element 10 (cf. Figure 4). As shown in Figure 1, the base body 12 comprises a plate-shaped base body portion 11 and an inner base body portion 20 integrally formed with the plate-shaped base body portion 11. The plate-shaped base body portion 11 comprises a plurality of inner recess portions 14a to 14c configured to define a fluid chamber for receiving a cooling fluid. The plate-shaped base body portion 11 further comprises a plurality of fluid openings 16a to 16c and a circumferential recess portion 18 surrounding the inner recess portions 14a to 14c. The fluid openings 16a to 16c are implemented to provide a fluidic connection between the fluid chamber defined by the inner recess portions 14a to 14c and a fluid inlet and a fluid outlet. The circumferential recess portion 18 is formed in an upper surface of the plate-shaped base body portion 11 and is configured for receiving a sealing element, such as a sealing gasket. As further shown in Figure 1, the inner base body portion 20 comprises a heat sink fin arrangement extending into the fluid chamber defined within the plate-shaped base body portion 11. More details of the heat sink fin arrangement are subsequently described with reference to Figure 2.

In particular, the base body 12 shown in Figure 1 is obtained by means of pressure die casting of the aluminum-silicon die casting alloy G-AlSi12.

Figure 2 shows a top view of the base body 12 according to Figure 1 illustrating the heat sink fin arrangement. In particular, the inner base body portion 20 comprises a plurality of protrusions 22a to 22o and 24a to 24o formed on an upper side of the inner base body portion 20. The protrusions 22a to 22o and 24a to 24o extend parallel to an upper surface of the plate-shaped base body portion 11 and define a plurality of fluid channels 23a to 23p and 25a to 25p extending parallel to the upper surface of the plate-shaped base body portion 11.

As shown in Figure 2, the heat sink fin arrangement comprises a first group of protrusions 22a to 22o and a second group of protrusions 24a to 24o arranged symmetrically with respect to a symmetry axis S of the plurality of protrusions 22a to 22o and 24a to 24o. The heat sink fin arrangement shown in Figure 2 can also be referred to as a non-linear array of heat sink fins. Here, the heat sink fins are formed by the plurality of protrusions 22a to 22o and 24a to 24o.

Referring to Figure 2, a first individual protrusion (i.e. any of the protrusions 22a to 22o of the first group) extends into a first longitudinal direction parallel to an upper surface of the plate-shaped base body portion 11 and a second individual protrusion (i.e. any of the protrusions 24a to 24o of the second group) extends into a second longitudinal direction parallel to the upper surface of the plate-shaped base body portion 11. In Figure 2, the direction of the input fluid flow is indicated by the arrow P1, while the first longitudinal direction and the second longitudinal direction are indicated by the arrows P2 and P3, respectively. Further referring to Figure 2, the extension of the first individual protrusion in the first longitudinal direction defines a first angle α₁ with respect to the symmetry axis S and the extension of the second individual protrusion in the second longitudinal direction defines a second angle α₂ with respect to the symmetry axis S. In the heat sink fin arrangement of Figure 2, the first angle α₁ and/or the second angle α₂ are equal to or larger than 15° and smaller than 90°. Thus, the non-linear array of heat sink fins shown in Figure 2 is substantially different from the known linear or straight heat sink fin structure 20' shown in Figure 5.

For obtaining an optimal fluid flow (which is symmetrical to the symmetry axis S), the first angle α₁ and the second angle α₂ are of the same size. Here, the total angle α₃ defined by the first longitudinal direction and the second longitudinal direction is equal to or larger than 30° and smaller than 180°. The provision of the heat sink fin arrangement of Figure 2 allows to increase the length of the fluid channels 23a to 23p and 25a to 25p, and thus the thermal performance of the fluid-based cooling element 10 can be improved.

As shown in Figure 2, the protrusions 22a to 22o of the first group and the protrusions 24a to 24o of the second group extend parallel to each other, respectively. Here, the protrusions 22a to 22o of the first group and the protrusions 24a to 24o of the second group have a same gap size D. The gap size D may be defined as an average of the minimum distance between two adjacent protrusions (i.e. protrusions 22a, 22b; 22b, 22c; ... 22n, 22o) of the first group or between two adjacent protrusions (i.e. protrusions 24a, 24b; 24b, 24c; ... 24n, 24o) of the second group. In particular, the protrusions 22a to 22o and 24a to 24o have a gap size D in a range of 0.5 mm to 1.5 mm. For example, the gap size D is in a range of 0.6 mm to 1.4 mm, 0.7 mm to 1.3 mm, 0.8 mm to 1.2 mm or 0.9 mm to 1.1 mm. Preferably, the gap size D is 1 mm ± 0.1 mm.

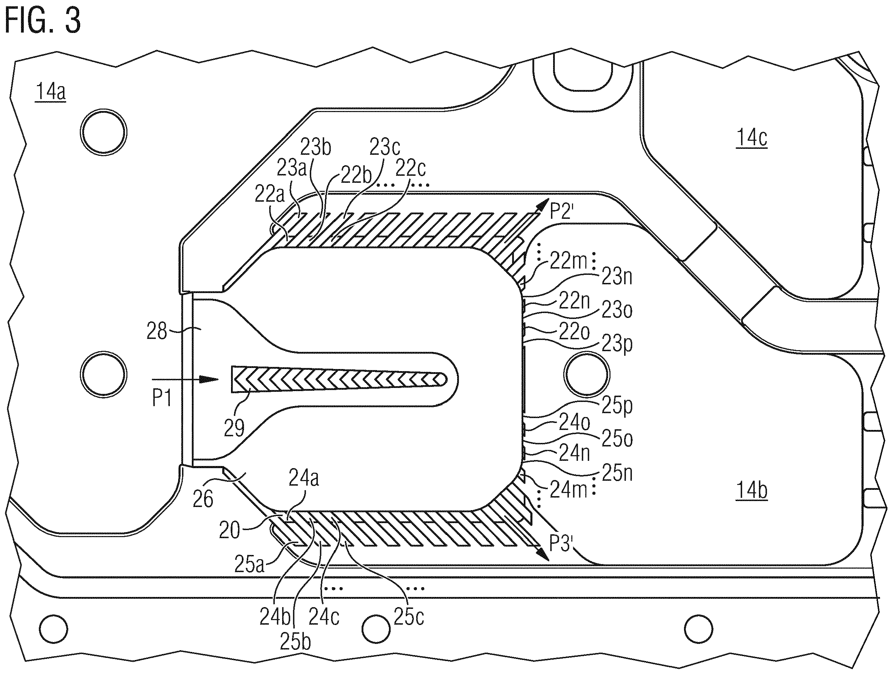

Figure 3 shows a top view of an exemplary nozzle body 26 arranged on the heat sink fin arrangement of the base body 12 according to Figure 1. The nozzle body 26 is obtained by means of die casting using an aluminum-based die casting alloy. As shown in Figure 3, the nozzle body 26 comprises an inner recess portion 28 tapering in the direction of the input fluid flow P1. As further shown in Figure 3, the nozzle body 26 comprises a longitudinally extending fluid inlet 29 configured to split the input fluid flow in the direction P1 into a first output fluid flow in the direction P2' and a second output fluid flow in the direction P3'. Here, the direction P2' and the direction P3' are parallel to the first longitudinal direction P2 and the second longitudinal direction P3 shown in Figure 2. Referring to Figure 3, the nozzle body 26 is arranged on the inner base body portion 20 such that the longitudinally extending fluid inlet 29 is aligned with the symmetry axis S of the plurality of protrusions 22a to 22o and 24a to 24o. By this arrangement of the nozzle body 26, it is possible to generate the split fluid flow in a controllable and reliable way.

Figure 4 shows an exploded view of the embodiment of the fluid-based cooling element 10 fixable to a printed circuit board 100. The printed circuit board 100 comprises a heat generating element 102 to be cooled (e.g. a high-power microprocessor). The fluid-based cooling element 10 is configured to be fixed to the printed circuit board 100 by means of fixing members 40. In particular, the fluid-based cooling element 10 is fixable to the printed circuit board 100 such that the inner base body portion 20 is arranged above the heat generating element 102. By providing a mechanical and thermal contact, the heat generating element 102 can efficiently be cooled by the fluid-based cooling element 10.

As shown in Figure 4, the fluid-based cooling element 10 comprises the base body 12 comprising the plate-shaped base body portion 11 and the inner base body portion 20 integrally formed with the plate-shaped base body portion 11. As further shown in Figure 4, the fluid-based cooling element 10 comprises a sealing element 30 configured to be received by the circumferential recess portion 18 formed in the upper surface of the plate-shaped base body portion 11. The fluid-based cooling element 10 further comprises the nozzle body 26 with the inner recess portion 28 configured to be arranged perpendicular above the inner base body portion 20 so as to be in mechanical and thermal contact with the heat sink fins formed on the upper side of the inner base body portion 20.

The fluid-based cooling element 10 further comprises a sealing body 32 configured to be arranged on the plate-shaped base body portion 11. The sealing body 32 is plate-shaped and can be fixed to the plate-shaped base body portion 11 by means of a plurality of fixing elements, such as screws 34. In the assembled state, the plate-shaped base body portion 11, the inner base body portion 20 and the sealing body 32 together define the fluid chamber. With reference to Figure 4, a connecting element 36 may be provided on one side of the base body 12 comprising a fluid inlet 38a and a fluid outlet 38b. By means of the fluid inlet 38a and the fluid outlet 38b, a controlled fluid flow though the fluid chamber defined within the plate-shaped base body portion 11 can be provided.

Embodiments of the invention provide a rapid production of high performance cold plates (i.e. the fluid-based cooling element 10) using a pressure die casting of the aluminum-based alloy G-AlSi12 where the complete cooling fin heat sink structure can be die casted in a single operation, without any further manufacturing process. Embodiments of the invention provide the advantage that the cooling fin gap size D can be as small as 1 mm or less. Contrary to the known pre-forming techniques, embodiments of the invention allow for the production of a high-density heat sink fin structure with filigrane heat sink cooling channels. Here, the use of the afore-mentioned alloy G-AlSi12 is preferred since it offers excellent die casting properties while maintaining a high thermal conductivity, casting yield rate and corrosion resistance.

The employed die casting alloy is substantially copper-free (<0.05 %) which further improves the reliability of the cold plate 10 by avoiding galvanic corrosion. Depending on the application, the following alloys can be used as well: G-AlSi7Mg, G-AlSi5Mg, G-AlMg3, G-AlMg5, G-AlMg5Si or G-AlSi10Mg.

Here, it should be noted that since pure aluminum has a low strength and is difficult to cast, it is typically used only for special applications such as electric motor components for which a high electric and thermal conductivity is required. However, the use of silicon (Si) as an exemplary additive in the employed aluminum alloys is advantageous since it lowers the melting point and increases the melt flow, fluidity, hardness and strength.

Instead of a linear array of heat sink fins according to the prior art, embodiments of the invention provide a non-linear cooling fin array design where the angle α₃ between both halfs of the heat sink fin structure is equal to or larger than 30° and smaller than 180°. This inventive design lengthens the cooling channels which in turn increases the effective heat sink surface (up to 40% compared to a straight fin array structure). Further, the hydraulic performance can be improved.

According to embodiments, a central fluid inlet split-flow design can be used in order to increase the thermal performance of the cold plate 10 while at the same time decreasing the hydraulic restriction. In particular, a central inlet split-flow nozzle 26 is provided which can also be made from a die casting aluminum-based alloy. This helps to improve the cooling performance of the cold plate 10 as the nozzle 26 and the cold plate fin structure are in a mechanical and thus thermal contact. Alternatively, the nozzle 26 can also be made from another material, like plastic, albeit without additional thermal performance gains.

In order to further increase the production rate, embodiments of the invention also allow for a welding of a sealing lid which eliminates the need for sealing gaskets and fasteners.

The invention also provides the advantage that due to the specific size or density of the cooling fin structure, there is substantially no danger of a heat induced deformation of the cooling fin array, especially when compared to a thinner structure made by using skiving or other material removal techniques.

### List of reference signs

- 10: fluid-based cooling element
- 11, 20: base body portion
- 12: base body
- 14a to 14c, 18, 28: recess portion
- 16a to 16c: fluid openings
- 22a to 22o, 24a to 24o: protrusion
- 23a to 23p, 25a to 25p: fluid channel
- 26: nozzle body
- 29, 38a: fluid inlet
- 30: sealing element
- 32: sealing body
- 34: screws
- 36: connecting element
- 38b: fluid outlet
- 40: fixing members
- 100: printed circuit board
- 102: heat generating element
- 12', 20': prior art component
- P1 to P3, P2', P3': direction
- α₁ to α₃: angle
- S: symmetry axis

## Claims

1. A method for manufacturing a fluid-based cooling element (10), wherein the fluid-based cooling element (10) is configured for cooling a heat generating element (102) arranged on a printed circuit board (PCB) (100), wherein the method comprises:
forming a base body (12) comprising a plate-shaped base body portion (11) and an inner base body portion (20) integrally formed with the plate-shaped base body portion (11),
wherein the step of forming the base body (12) comprises forming the plate-shaped base body portion (11) and the inner base body portion (20) by means of die casting,
wherein the inner base body portion (20) comprises a plurality of protrusions (22a-22o, 24a-24o) formed on an upper side of the inner base body portion (20),
wherein the plurality of protrusions (22a-22o, 24a-24o) comprises a first group of protrusions (22a-22o) and a second group of protrusions (24a-24o),
wherein the protrusions (22a-22o, 24a-24o) define a plurality of fluid channels (23a-23p, 25a-25p) extending parallel to the upper surface of the plate-shaped base body portion (11),
wherein any of the protrusions (22a-22o) of the first group extends into a first longitudinal direction (P2) parallel to an upper surface of the plate-shaped base body portion (11),
wherein any of the protrusions (24a-24o) of the second group extends into a second longitudinal direction (P3) parallel to the upper surface of the plate-shaped base body portion (11),
wherein the extension of the protrusions of the first group in the first longitudinal direction (P2) defines a first angle (α₁) with respect to a symmetry axis (S) of the plurality of protrusions (22a-22o, 24a-24o) extending parallel to the upper surface of the plate-shaped base body portion (11),
wherein the extension of the protrusions of the second group in the second longitudinal direction (P3) defines a second angle (α₂) with respect to the symmetry axis (S) of the plurality of protrusions (22a-22o, 24a-24o) extending parallel to the upper surface of the plate-shaped base body portion (11),
wherein the first angle (α₁) and/or the second angle (α₂) are equal to or larger than 15° and smaller than 90°, and
wherein the protrusions (22a-22o, 24a-24o) have a gap size (D), defined as an average of the minimum distance between two adjacent protrusions (22a-22o) of the first group or between two adjacent protrusions (24a-24o) of the second group, in a range of 0.5 mm to 1.5 mm.

2. The method according to claim 1, wherein the protrusions (22a-22o, 24a-24o) have a gap size (D) of approximately 1 mm.

3. The method according to claim 1 or 2, wherein the step of forming the base body (12) comprises using an aluminum-silicon die casting alloy, wherein the aluminum-silicon die casting alloy is G-AlSi12.

4. The method according to claim 3, wherein the aluminum-silicon die casting alloy G-AlSi12 is substantially free of copper.

5. The method according to claim 1 or 2, wherein the step of forming the base body (12) comprises using an aluminum-silicon-magnesium die casting alloy or using an aluminum-magnesium die casting alloy.

6. The method according to claim 5, wherein the aluminum-silicon-magnesium die casting alloy is G-AlSi7Mg, G-AlSi5Mg, G-AlMg5Si or G-AlSi10Mg, and wherein the aluminum-magnesium die casting alloy is G-AlMg3 or G-AlMg5.

7. The method according to one of the claims 1 to 6, wherein the protrusions (22a-22o, 24a-24o) extend parallel to an upper surface of the plate-shaped base body portion (11), and wherein the protrusions (22a-22o, 24a-24o) are configured as a heat sink fin arrangement.

8. The method according to one of the claims 1 to 7, wherein the first angle (α₁) and the second angle (α₂) are of the same size.

9. The method according to one of the claims 1 to 8, wherein the method further comprises forming a nozzle body (26) comprising a longitudinally extending fluid inlet (29), wherein the step of forming the nozzle body (26) comprises using an aluminum-based die casting alloy.

10. The method according to claim 9, wherein the method further comprises arranging the nozzle body (26) on the inner base body portion (20), wherein the longitudinally extending fluid inlet (29) is arranged perpendicular above a symmetry axis (S) of the plurality of protrusions (22a-22o, 24a-24o) formed on the upper side of the inner base body portion (20).

11. The method according to one of the claims 1 to 10, wherein the method further comprises arranging a sealing element (30) on or in the plate-shaped base body portion (11).

12. The method according to one of the claims 1 to 11, wherein the method further comprises arranging a sealing body (32) on the plate-shaped base body portion (11), wherein the plate-shaped base body portion (11), the inner base body portion (20) and the sealing body (32) together define a fluid chamber, wherein the fluid chamber is configured for receiving a cooling fluid.

13. The method according to one of the claims 1 to 12, wherein the step of forming the base body (12) comprises forming the plate-shaped base body portion (11) and the inner base body portion (20) in a single processing step.

14. A fluid-based cooling element (10) for cooling a heat generating element (102) arranged on a printed circuit board (100), wherein the fluid-based cooling element (10) comprises:
a base body (12) comprising a plate-shaped base body portion (11) and an inner base body portion (20) integrally formed with the plate-shaped base body portion (11), wherein the plate-shaped base body portion (11) and the inner base body portion (20) are formed by means of die casting,
wherein the inner base body portion (20) comprises a plurality of protrusions (22a-22o, 24a-24o) formed on an upper side of the inner base body portion (20),
wherein the plurality of protrusions (22a-22o, 24a-24o) comprises a first group of protrusions (22a-22o) and a second group of protrusions (24a-24o),
wherein the protrusions (22a-22o, 24a-24o) define a plurality of fluid channels (23a-23p, 25a-25p) extending parallel to the upper surface of the plate-shaped base body portion (11),
wherein any of the protrusions (22a-22o) of the first group extends into a first longitudinal direction (P2) parallel to an upper surface of the plate-shaped base body portion (11),
wherein any of the protrusions (24a-24o) of the second group extends into a second longitudinal direction (P3) parallel to the upper surface of the plate-shaped base body portion (11),
wherein the extension of the protrusions of the first group in the first longitudinal direction (P2) defines a first angle (α₁) with respect to a symmetry axis (S) of the plurality of protrusions (22a-22o, 24a-24o) extending parallel to the upper surface of the plate-shaped base body portion (11),
wherein the extension of the protrusions of the second group in the second longitudinal direction (P3) defines a second angle (α₂) with respect to the symmetry axis (S) of the plurality of protrusions (22a-22o, 24a-24o) extending parallel to the upper surface of the plate-shaped base body portion (11),
wherein the first angle (α₁) and/or the second angle (α₂) are equal to or larger than 15° and smaller than 90°, and
wherein the protrusions (22a-22o, 24a-24o) have a gap size (D), defined as an average of the minimum distance between two adjacent protrusions (22a-22o, 24a-24o), in a range of 0.5 mm to 1.5 mm.

## Patentansprüche

1. Verfahren zum Herstellen eines fluidbasierten Kühlelements (10), wobei das fluidbasierte Kühlelement (10) ausgebildet ist, um ein auf einer Leiterplatte (PCB) (100) angeordnetes Wärmeerzeugungselement zu kühlen, wobei das Verfahren umfasst:
Bilden eines Basiskörpers (12), der einen plattenförmigen Basiskörperabschnitt (11) und einen inneren Basiskörperabschnitt (20) umfasst, der integral mit dem plattenförmigen Basiskörperabschnitt (11) ausgebildet ist,
wobei der Schritt des Bildens des Basiskörpers (12) das Bilden des plattenförmigen Basiskörperabschnitts (11) und des inneren Basiskörperabschnitts (20) mittels Druckguss umfasst,
wobei der innere Basiskörperabschnitt (20) eine Vielzahl von Vorsprüngen (22a-22o, 24a-24o) umfasst, die auf einer oberen Seite des inneren Basiskörperabschnitts (20) gebildet ist,
wobei die Vielzahl von Vorsprüngen (22a-22o, 24a-24o) eine erste Gruppe von Vorsprüngen (22a-22o) und eine zweite Gruppe von Vorsprüngen (224a-24o) umfasst,
wobei die Vorsprünge (22a-22o, 24a-24o) eine Vielzahl von Fluidkanälen (23a-23p, 25a-25p) definieren, die sich parallel zur oberen Fläche des plattenförmigen Basiskörperabschnitts (11) erstrecken,
wobei sich jeder der Vorsprünge (22a-22o) der ersten Gruppe in eine erste Längsrichtung (P2) parallel zu einer oberen Fläche des plattenförmigen Basiskörperabschnittes (11) erstreckt,
wobei sich jeder der Vorsprünge (24a-24o) der zweiten Gruppe in eine zweite Längsrichtung (P3) parallel zur oberen Fläche des plattenförmigen Basiskörperabschnitts (11) erstreckt,
wobei die Ausdehnung der Vorsprünge der ersten Gruppe in der ersten Längsrichtung (P2) einen ersten Winkel (α1) in Bezug auf eine Symmetrieachse (S) der Vielzahl von Vorsprüngen (22a-22o, 24a-24o) definiert, die sich parallel zur oberen Fläche des plattenförmigen Basisköperabschnitts (11) erstreckt,
wobei die Ausdehnung der Vorsprünge der zweiten Gruppe in der zweiten Längsrichtung (P3) einen zweiten Winkel (α2) in Bezug auf eine Symmetrieachse (S) der Vielzahl von Vorsprüngen (22a-22o, 24a-24o) definiert, die sich parallel zur oberen Fläche des plattenförmigen Basiskörperabschnitts (11) erstreckt,
wobei der erste Winkel (α1) und/oder der zweite Winkel (α2) gleich oder größer als 15° und kleiner als 90° sind, und
wobei die Vorsprünge (22a-22o, 24a-24o) eine Spaltgröße (D), die als ein Durchschnitt des Mindestabstands zwischen zwei angrenzenden Vorsprüngen (22a-22o) der ersten Gruppe oder zwischen zwei angrenzenden Vorsprüngen (24a-24o) der zweiten Gruppe definiert ist, in einem Bereich von 0,5 mm bis 1,5 mm haben.

2. Verfahren nach Anspruch 1, wobei die Vorsprünge (22a-22o, 24a-24o) eine Spaltgröße (D) von näherungsweise 1 mm haben.

3. Verfahren nach Anspruch 1 oder 2, wobei der Schritt des Bildens des Basiskörpers (12) die Verwendung einer Aluminium-Silizium-Druckgußlegierung umfasst, wobei die Aluminium-Silizium-Druckgußlegierung G-AlSi12 ist.

4. Verfahren nach Anspruch 3, wobei die Aluminium-Silizium-Druckgußlegierung G-AlSi12 im Wesentlichen frei von Kupfer ist.

5. Verfahren nach Anspruch 1 oder 2, wobei der Schritt des Bildens des Basiskörpers (12) die Verwendung einer Aluminium-Silizium-Magnesium-Druckgußlegierung oder die Verwendung einer Aluminium-Magnesium-Druckgußlegierung umfasst.

6. Verfahren nach Anspruch 5, wobei die Aluminium-Silizium-Magnesium-Druckguß-Legierung G-AlSi7Mg, G-AlSi5Mg, G-AlMg5Si oder G-AlSi10Mg ist und wobei die Aluminium-Magnesium-Druckgußlegierung G-AlMg3 oder G-AlMg5 ist.

7. Verfahren nach einem der Ansprüche 1 bis 6, wobei sich die Vorsprünge (22a-22o, 24a-24o) parallel zu einer oberen Fläche des plattenförmigen Basiskörperabschnittes (11) erstrecken und wobei die Vorsprünge (22a-22o, 24a-24o) als Kühlkörper-Rippenanordnung ausgebildet sind.

8. Verfahren nach einem der Ansprüche 1 bis 7, wobei der erste Winkel (α1) und der zweite Winkel (α2) die gleiche Größe haben.

9. Verfahren nach einem der Ansprüche 1 bis 8, wobei das Verfahren ferner das Bilden eines Düsenkörpers (26) umfasst, der einen sich in Längsrichtung erstreckenden Fluideinlass (29) umfasst, wobei der Schritt des Bildens des Düsenkörpers (26) die Verwendung einer aluminiumbasierten Druckgußlegierung umfasst.

10. Verfahren nach Anspruch 9, wobei das Verfahren ferner das Anordnen des Düsenkörpers (26) an dem inneren Basiskörperabschnitt (20) umfasst, wobei der sich in Längsrichtung erstreckende Fluideinlass (29) senkrecht über einer Symmetrieachse (S) der Vielzahl von Vorsprüngen (22a-22o, 24a-24o) angeordnet ist, die auf der oberen Seite des inneren Basiskörperabschnitts (20) gebildet ist.

11. Verfahren nach einem der Ansprüche 1 bis 10, wobei das Verfahren ferner das Anordnen eines Dichtungselements (30) auf oder in dem plattenförmigen Basiskörperabschnitt (11) umfasst.

12. Verfahren nach einem der Ansprüche 1 bis 11, wobei das Verfahren ferner das Anordnen eines Dichtungskörpers (32) auf dem plattenförmigen Basiskörperabschnitt (11) umfasst, wobei der plattenförmige Basiskörperabschnitt (11), der innere Basiskörperabschnitt (20) und der Dichtungskörper (32) zusammen eine Fluidkammer definieren, wobei die Fluidkammer ausgebildet ist, um ein Kühlfluid aufzunehmen.

13. Verfahren nach einem der Ansprüche 1 bis 12, wobei der Schritt des Bildens des Basiskörpers (12) das Bilden des plattenförmigen Basiskörperabschnitts (11) und des inneren Basiskörperabschnitts (20) in einem einzigen Verarbeitungsschritt umfasst.

14. Fluidbasiertes Kühlelement (10) zum Kühlen eines Wärmeerzeugungselements (102), das auf einer Leiterplatte (100) angeordnet ist, wobei das fluidbasierte Kühlelement (10) umfasst:
einen Basiskörper (12), der einen plattenförmigen Basiskörperabschnitt (11) und einen inneren Basiskörperabschnitt (20) umfasst, der integral mit dem plattenförmigen Basiskörperabschnitt (11) ausgebildet ist, wobei der plattenförmige Basiskörperabschnitt (11) und der innere Basiskörperabschnitt (20) mittels Druckguß gebildet werden,
wobei der innere Basiskörperabschnitt (20) eine Vielzahl von Vorsprüngen (22a-22o, 24a-24o) umfasst, die auf einer oberen Seite des inneren Basiskörperabschnitts (20) gebildet sind,
wobei die Vielzahl von Vorsprüngen (22a-22o, 24a-24o) eine erste Gruppe von Vorsprüngen (22a-22o) und eine zweite Gruppe von Vorsprüngen (24a-24o) umfasst,
wobei die Vorsprünge (22a-22o, 24a-24o) eine Vielzahl von Fluidkanälen (23a-23p, 25a-25p) definieren, die sich parallel zur oberen Fläche des plattenförmigen Basiskörperabschnitts (11) erstrecken,
wobei sich jeder der Vorsprünge (22a-22o) der ersten Gruppe in eine erste Längsrichtung (P2) parallel zu einer oberen Fläche des plattenförmigen Basiskörperabschnitts (11) erstreckt,
wobei sich jeder der Vorsprünge (24a-24o) der zweiten Gruppe in eine zweite Längsrichtung (P3) parallel zu der oberen Fläche des plattenförmigen Basiskörperabschnitts (11) erstreckt,
wobei die Ausdehnung der Vorsprünge der ersten Gruppe in der ersten Längsrichtung (P2) einen ersten Winkel (α1) in Bezug auf eine Symmetrieachse (S) der Vielzahl von Vorsprüngen (22a-22o, 24a-24o) definiert, die sich parallel zur oberen Fläche des plattenförmigen Basiskörperabschnitts (11) erstreckt,
wobei die Ausdehnung der Vorsprünge der zweiten Gruppe in der zweiten Längsrichtung (P3) einen zweiten Winkel (α2) in Bezug auf die Symmetrieachse (S) der Vielzahl von Vorsprüngen (22a-22o, 24a-24o) definiert, die sich parallel zu der oberen Fläche des plattenförmigen Basiskörperabschnitts (11) erstreckt,
wobei der erste Winkel (α1) und/oder der zweite Winkel (α2) gleich oder größer als 15° und kleiner als 90° sind, und
wobei die Vorsprünge (22a-22o, 24a-24o) eine Spaltgröße (D), die als Durchschnitt des Mindestabstandes zwischen zwei angrenzenden Vorsprüngen (22a-22o, 24a-24o) definiert ist, in einem Bereich von 0,5 mm bis 1,5 mm haben.

## Revendications

1. Procédé de fabrication d'un élément de refroidissement à base de fluide (10), dans lequel l'élément de refroidissement à base de fluide (10) est configuré pour refroidir un élément générateur de chaleur (102) disposé sur une carte de circuit imprimé (PCB) (100), dans lequel le procédé comprend :
la formation d'un corps de base (12) comprenant une partie de corps de base en forme de plaque (11) et une partie de corps de base interne (20) formée d'un seul tenant avec la partie de corps de base en forme de plaque (11),
dans lequel l'étape de formation du corps de base (12) comprend la formation de la partie de corps de base en forme de plaque (11) et de la partie de corps de base interne (20) au moyen d'un moulage sous pression,
dans lequel la partie de corps de base interne (20) comprend une pluralité de protubérances (22a-22o, 24a-24o) formées sur un côté supérieur de la partie de corps de base interne (20),
dans lequel la pluralité de protubérances (22a-22o, 24a-24o) comprend un premier groupe de protubérances (22a-22o) et un second groupe de protubérances (24a-24o),
dans lequel les protubérances (22a-22o, 24a-24o) définissent une pluralité de canaux de fluide (23a-23p, 25a-25p) qui s'étendent parallèlement à la surface supérieure de la partie de corps de base en forme de plaque (11),
dans lequel l'une quelconque des protubérances (22a-22o) du premier groupe s'étend dans une première direction longitudinale (P2) parallèle à une surface supérieure de la partie de corps de base en forme de plaque (11),
dans lequel l'une quelconque des protubérances (24a-24o) du second groupe s'étend dans une seconde direction longitudinale (P3) parallèle à la surface supérieure de la partie de corps de base en forme de plaque (11),
dans lequel l'extension des protubérances du premier groupe dans la première direction longitudinale (P2) définit un premier angle (α1) par rapport à un axe de symétrie (S) de la pluralité de protubérances (22a-22o, 24a-24o) qui s'étendent parallèlement à la surface supérieure de la partie de corps de base en forme de plaque (11),
dans lequel l'extension des protubérances du second groupe dans la seconde direction longitudinale (P3) définit un second angle (α2) par rapport à l'axe de symétrie (S) de la pluralité de protubérances (22a-22o, 24a-24o) qui s'étendent parallèlement à la surface supérieure de la partie de corps de base en forme de plaque (11),
dans lequel le premier angle (α1) et/ou le second angle (α2) sont égaux ou supérieurs à 15° et inférieurs à 90°, et
dans lequel les protubérances (22a-22o, 24a-24o) ont une taille d'intervalle (D), définie comme étant une moyenne de la distance minimale entre deux protubérances adjacentes (22a-22o) du premier groupe ou entre deux protubérances adjacentes (24a-24o) du second groupe, dans une plage de 0,5 mm à 1,5 mm.

2. Procédé selon la revendication 1, dans lequel les protubérances (22a-22o, 24a-24o) ont une taille d'intervalle (D) d'environ 1 mm.

3. Procédé selon la revendication 1 ou 2, dans lequel l'étape de formation du corps de base (12) comprend l'utilisation d'un alliage de moulage sous pression d'aluminium-silicium, dans lequel l'alliage de moulage sous pression d'aluminium-silicium est G-AlSi12.

4. Procédé selon la revendication 3, dans lequel l'alliage de moulage sous pression d'aluminium-silicium G-AlSi12 est sensiblement exempt de cuivre.

5. Procédé selon la revendication 1 ou 2, dans lequel l'étape de formation du corps de base (12) comprend l'utilisation d'un alliage de moulage sous pression d'aluminium-silicium-magnésium ou l'utilisation d'un alliage de moulage sous pression d'aluminium-magnésium.

6. Procédé selon la revendication 5, dans lequel l'alliage de moulage sous pression d'aluminium-silicium-magnésium est G-AlSi7Mg, G-AlSi5Mg, G-AlMg5Si ou G-AlSi10Mg et dans lequel l'alliage de moulage sous pression d'aluminium-magnésium est G-AlMg3 ou G-AlMg5.

7. Procédé selon l'une des revendications 1 à 6, dans lequel les protubérances (22a-22o, 24a-24o) s'étendent parallèlement à une surface supérieure de la partie de corps de base en forme de plaque (11), et dans lequel les protubérances (22a-22o, 24a-24o) sont configurées sous la forme d'un agencement d'ailettes de dissipation de chaleur.

8. Procédé selon l'une des revendications 1 à 7, dans lequel le premier angle (α1) et le second angle (α2) sont de même taille.

9. Procédé selon l'une des revendications 1 à 8, dans lequel le procédé comprend en outre la formation d'un corps de buse (26) comprenant une entrée de fluide qui s'étend longitudinalement (29), dans lequel l'étape de formation du corps de buse (26) comprend l'utilisation d'un alliage de moulage sous pression à base d'aluminium.

10. Procédé selon la revendication 9, dans lequel le procédé comprend en outre l'agencement du corps de buse (26) sur la partie de corps de base interne (20), dans lequel l'entrée de fluide qui s'étend longitudinalement (29) est agencée perpendiculairement au-dessus d'un axe de symétrie (S) de la pluralité de protubérances (22a-22o, 24a-24o) formées sur le côté supérieur de la partie de corps de base interne (20).

11. Procédé selon l'une des revendications 1 à 10, dans lequel le procédé comprend en outre l'agencement d'un élément étanche (30) sur ou dans la partie de corps de base en forme de plaque (11).

12. Procédé selon l'une des revendications 1 à 11, dans lequel le procédé comprend en outre l'agencement d'un corps étanche (32) sur la partie de corps de base en forme de plaque (11), dans lequel la partie de corps de base en forme de plaque (11), la partie de corps de base interne (20) et le corps étanche (32) définissent ensemble une chambre à fluide, dans lequel la chambre à fluide est configurée pour recevoir un fluide de refroidissement.

13. Procédé selon l'une des revendications 1 à 12, dans lequel l'étape de formation du corps de base (12) comprend la formation de la partie de corps de base en forme de plaque (11) et de la partie de corps de base interne (20) en une seule étape de traitement.

14. Élément de refroidissement à base de fluide (10) pour refroidir un élément générateur de chaleur (102) disposé sur une carte de circuit imprimé (100), dans lequel l'élément de refroidissement à base de fluide (10) comprend :
un corps de base (12) comprenant une partie de corps de base en forme de plaque (11) et une partie de corps de base interne (20) formée d'un seul tenant avec la partie de corps de base en forme de plaque (11), dans lequel la partie de corps de base en forme de plaque (11) et la partie de corps de base interne (20) sont formées au moyen d'un moulage sous pression,
dans lequel la partie de corps de base interne (20) comprend une pluralité de protubérances (22a-22o, 24a-24o) formées sur un côté supérieur de la partie de corps de base interne (20),
dans lequel la pluralité de protubérances (22a-22o, 24a-24o) comprend un premier groupe de protubérances (22a-22o) et un second groupe de protubérances (24a-24o),
dans lequel les protubérances (22a-22o, 24a-24o) définissent une pluralité de canaux de fluide (23a-23p, 25a-25p) qui s'étendent parallèlement à la surface supérieure de la partie de corps de base en forme de plaque (11),
dans lequel l'une quelconque des protubérances (22a-22o) du premier groupe s'étend dans une première direction longitudinale (P2) parallèle à une surface supérieure de la partie de corps de base en forme de plaque (11),
dans lequel l'une quelconque des protubérances (24a-24o) du second groupe s'étend dans une seconde direction longitudinale (P3) parallèle à la surface supérieure de la partie de corps de base en forme de plaque (11),
dans lequel l'extension des protubérances du premier groupe dans la première direction longitudinale (P2) définit un premier angle (α1) par rapport à un axe de symétrie (S) de la pluralité de protubérances (22a-22o, 24a-24o) qui s'étendent parallèlement à la surface supérieure de la partie de corps de base en forme de plaque (11),
dans lequel l'extension des protubérances du second groupe dans la seconde direction longitudinale (P3) définit un second angle (α2) par rapport à l'axe de symétrie (S) de la pluralité de protubérances (22a-22o, 24a-24o) qui s'étendent parallèlement à la surface supérieure de la partie de corps de base en forme de plaque (11),
dans lequel le premier angle (α1) et/ou le second angle (α2) sont égaux ou supérieurs à 15° et inférieurs à 90°, et
dans lequel les protubérances (22a-22o, 24a-24o) ont une taille d'intervalle (D), définie comme une moyenne de la distance minimale entre deux protubérances adjacentes (22a-22o, 24a-24o), dans une plage de 0,5 mm à 1,5 mm.
